Europäisches Patentamt

European Patent Office

Office européen des brevets

(19)

(11) Veröffentlichungsnummer: **0 259 629**

**A1**

(12) **EUROPÄISCHE PATENTANMELDUNG**

(21) Anmeldenummer: **87111571.3**

(22) Anmeldetag: **10.08.87**

(51) Int. Cl.⁴: **H01L 21/225** , H01L 21/82

(30) Priorität: **19.08.86 DE 3628014**

(43) Veröffentlichungstag der Anmeldung:
**16.03.88 Patentblatt 88/11**

(84) Benannte Vertragsstaaten:
**AT DE FR GB IT NL**

(71) Anmelder: **Siemens Aktiengesellschaft Berlin und München**
**Wittelsbacherplatz 2**
**D-8000 München 2(DE)**

(72) Erfinder: **Binder, Harald, Dr. rer. nat.**
**Partnachplatz 7**
**D-8000 München 70(DE)**
Erfinder: **Geiger, Heinrich, Dr. rer. nat.**
**Andreas-Mitterfelner-Strasse 10**
**D-8150 Holzkirchen(DE)**
Erfinder: **Hönlein, Wolfgang, Dr. rer. nat.**
**Ludwig-Thoma-Strasse 60**
**D-8025 Unterhaching(DE)**
Erfinder: **Sedlak, Franz, Dipl.-Phys.**
**Weidenstrasse 14**
**D-8011 Baldham(DE)**

(54) **Verfahren zum Herstellen einer definierten Dotierung in den vertikalen Seitenwänden und den Böden von in Halbleitersubstrate eingebrachten Gräben.**

(57) Verfahren zum Herstellen einer definierten Dotierung in Seitenwänden (4) und Böden (5) von Gräben (2) in Halbleitersubstraten (1) durch Reinigen der Seitenwände (4) und der Böden (5) mittels eines Hochtemperaturprozesses und anschließenden epitaktischen Abscheidens einer Schicht (6) aus den Halbleitermaterial des Substrats (1), die den die definierte Dotierung bildenden Dotierungsstoff enthält.

EP 0 259 629 A1

## Verfahren zum Herstellen einer definierten Dotierung in den vertikalen Seitenwänden und den Böden von in Halbleitersubstrate eingebrachten Gräben.

Die vorliegende Erfindung betrifft ein Verfahren zum Herstellen einer definierten Dotierung in in Halbleitersubstrate eingebrachten Gräben nach dem Oberbegriff des Patentanspruchs 1.

Die zunehmende Verkleinerung in integrierten Schaltungen benötigt neue Techniken für die Unterbringung der Bauelementstrukturen. Mit zunehmender Speicherkapazität von zum Beispiel dynamischen RAMs (= random excess memory = Speicherzelle mit wahlfreiem Zugriff) wird der für eine Speicherzelle zur Verfügung stehende Platz immer geringer. Die minimale Fläche des Speicherkondensators wird jedoch durch die Kapazität bestimmt, die notwendig ist, um genügend Ladungen für einen zuverlässigen Betrieb zu speichern.

Eine Möglichkeit, die Kondensatorfläche ohne zusätzlichen Platzbedarf zu vergrößern, besteht in der Verwendung sogenannter Grabenzellen, wie sie beispielsweise in einem Bericht von P. Morie, K. Minegishi und S. Nakajima im IEEE Electron Device Letters, Vol. EDL-4, No. 11, November 1983, auf den Seiten 411 bis 414 oder in einem Bericht von Minegishi, Nakajima, Miura, Harada und Toshitaka in den Proceedings of the IEEE International Electron Devices Meeting, Dezember 1983, auf den Seiten 319 bis 322 beschrieben sind. Ein Problem stellt dabei die Erzeugung eines definierten Dotierprofils an den vertikalen Seitenwänden des Grabens dar. Für das Beispiel dere Grabenzelle sollte dieses Profil flach sein, um Leckströme zwischen eng benachbarten Grabenzellen zu verhindern.

In der deutschen Patentanmeldung P 36 02 044.3 ist ein Verfahren beschrieben, bei dem die in Rede stehende Dotierung durch Ionenimplantation und anschließendes Tempern hergestellt wird, wobei während der Ionenimplantation eine Relativbewegung zwischen Ionenstrahl und Substrat durchgeführt wird, so daß ein Teil der Ionen unter streifendem Einfallwinkel auf die Wandungen der Gräben auftrifft.

Weiterhin können die Dotierungsstoffe aus dotierten, auf die Grabenwandungen abgeschiedenen Oxiden in das Substratmaterial ausdiffundiert werden.

Bei dem erstgenannten Verfahren ist für die mechanische Relativbewegung zur Realisierung des gewünschten Einfallswinkels ein relativ großer feinmechanischer Aufwand erforderlich, während das zweitgenannte Verfahren mit einer hohen Temperatur-Zeit-Belastung und einer schwierigen Kontrolle der Flächenkonzentration des Dotierungsstoffes verbunden ist.

Direkte Diffusions-Dotierverfahren scheiden wegen der hohen Konzentration an hochgiftigen Reaktionsprodukten (z.B. $As_2O_3$ bei Arsen als Dotierungsstoff) aus.

Der vorliegenden Erfindung liegt die Aufgabe zugrunde, ein Verfahren der in Rede stehenden Art anzugeben, das ohne nachteilige Einflüsse durch den Dotierungsprozeß selbst zu reproduzierbaren Ergebnissen führt.

Diese Aufgabe wird bei einem Verfahren der eingangs genannten Art erfindungsgemäß durch die Merkmale des kennzeichnenden Teils des Patentanspruchs 1 gelöst.

Weiterbildungen des Erfindungsgedankens sind Gegenstand von Unteransprüchen.

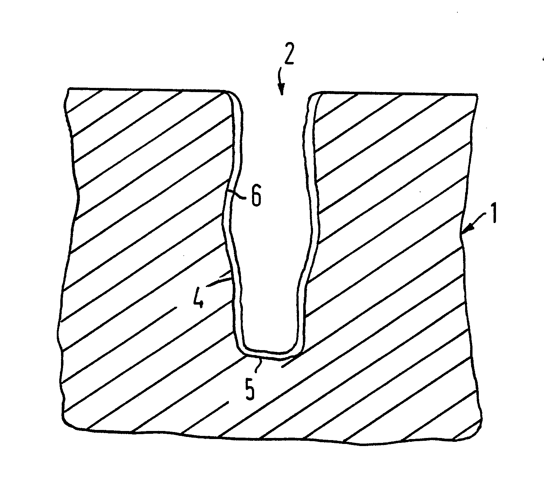

Die Erfindung wird im folgenden anhand eines in der einzigen Figur der Zeichnung dargestellten Ausführungsbeispiels näher erläutert.

Die Figur zeigt schematisch einen Schnitt durch einen in einem Siliziumsubstrat vorgesehenen Graben nach Aufbringung einer den Dotierungsstoff enthaltenden epitaxischen Schicht.

Die Figur zeigt ein durch Silizium als Halbleitermaterial gebildetes Substrat 1, in das ein Graben 2 eingebracht ist. Seitenwände 4 und ein Boden 5 des Grabens 2 werden zunächst einem Hochtemperaturprozeß unterworfen, der vorzugsweise mittels eines Wasserstoff/Chlorwasserstoff-Gemisches bei einer Temperatur in der Größenordnung von 1050°C durchgeführt wird. Dabei erfolgt eine Verrundung der Grabenwandungen und deren Reinigung, wie sie schematisch in der Figur dargestellt ist. In einem nachfolgenden Schritt wird auf die Seitenwandungen des Grabens 2 eine epitaxische Schicht 6 aus dem Halbleitermaterial des Substrats 1 - im vorliegenden Beispiel Silizium - aufgebracht, die gleichzeitig mit dem gewünschten Dotierungsstoff, beispielsweise Arsen, dotiert ist. Dies erfolgt vorzugsweise bei Temperaturen in der Größenordnung von 950°C. Auch bei dem epitaktischen Abscheidungsprozeß wird Chlorwasserstoff zugesetzt.

Der Hochtemperaturreinigungsprozeß und die epitaktische Abscheidung können unmittelbar aufeinanderfolgend im gleichen Epitaxiereaktor durchgeführt werden.

Unter den genannten Bedingungen ist beispielsweise eine epitaktische Schicht mit einer Dicke von 0,15 $\mu$m bei einer Arsen-Dotierungskonzentration von 5 x $10^{18}cm^3$ in Gräben 2 mit einer Tiefe von etwa 5 $\mu$m und einem Durchmesser von 0,7 $\mu$m erreichbar.

## Ansprüche

1. Verfahren zum Herstellen einer definierten Dotierung in den vertikalen Seitenwänden und den Böden von in Halbleitersubstrate eingebrachten Gräben, wie sie insbesondere für Speicherkondensatoren in Form von Grabzellen in Siliziumsubstraten in sub $\mu$m-Bereich verwendet werden **dadurch gekennzeichnet,** daß die Gräben (2) zu ihrer Verrundung und Reinigung zunächst einem Hochtemperaturprozeß unterworfen werden und daß auf die gereinigten Graben-Seitenwände und -böden (4,5) epitaktisch eine Schicht (6) des das Halbleitersubstrat (1) bildenden Halbleitermaterials abgeschieden wird, die den die definierte Dotierung bildenden Dotierungsstoff enthält.

2. Verfahren nach Anspruch 1, **dadurch gekennzeichnet,** daß der Hochtemperaturprozeß mittels eines Wasserstoff/Chlorwasserstoff-Gemisches bei einer Temperatur in der Größenordnung von 1050°C durchgeführt wird.

3. Verfahren nach Anspruch 1 und 2, **dadurch gekennzeichnet,** daß die epitakische Abscheidung unter Zusetzung des Dotierungsstoffes, vorzugsweise Arsen, und Chlorwasserstof bei einer Temperatur in der Größenordnung von 950°C durchgeführt wird.

4. Verfahren nach einem der Ansprüche 1 bis 3, **dadurch gekennzeichnet,** daß der Hochtemperaturreinigungsprozeß und der epitaktische Abscheidungsprozeß unmittelbar aufeinanderfolgend im gleichen Epitaxiereaktor durchgeführt werden.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | WO-A-8 504 760 (AMERICAN TELEPHONE & TELEGRAPH CO.)<br>* Ansprüche 1,2 *<br>--- | 1 | H 01 L 21/225<br>H 01 L 21/82 |
| A | EP-A-0 171 131 (NIPPON TELEGRAPH AND TELEPHONE CORP.)<br>* Zusammenfassung *<br>--- | 1 | |
| A | WO-A-8 603 620 (NCR CORP.)<br>* Zusammenfassung *<br>--- | 1 | |
| A | EP-A-0 099 270 (TOKYO DENKI SEIZO K.K.)<br>* Anspruch 1; Figuren 3b,3c *<br>----- | 1 | |

RECHERCHIERTE SACHGEBIETE (Int. Cl.4)

H 01 L

Der vorliegende Recherchenbericht wurde für alle Patentansprüche erstellt

| Recherchenort | Abschlußdatum der Recherche | Prüfer |
|---|---|---|
| DEN HAAG | 18-11-1987 | ZOLLFRANK G.O. |

EPO FORM 1503 03.82 (P0403)